(19) Europäisches Patentamt
European Patent Office
Office européen des brevets

(11) **EP 1 665 536 B1**

(12) **EUROPÄISCHE PATENTSCHRIFT**

(45) Veröffentlichungstag und Bekanntmachung des Hinweises auf die Patenterteilung:
**11.04.2007   Patentblatt 2007/15**

(21) Anmeldenummer: **04765063.5**

(22) Anmeldetag: **10.09.2004**

(51) Int Cl.:
**H03K 17/95** (2006.01)

(86) Internationale Anmeldenummer:
**PCT/EP2004/010136**

(87) Internationale Veröffentlichungsnummer:
**WO 2005/027347 (24.03.2005 Gazette 2005/12)**

(54) **INDUKTIVER SCHALTER**

INDUCTIVE SWITCH

COMMUTATEUR INDUCTIF

(84) Benannte Vertragsstaaten:
**AT BE BG CH CY CZ DE DK EE ES FI FR GB GR HU IE IT LI LU MC NL PL PT RO SE SI SK TR**

(30) Priorität: **11.09.2003   WOPCT/EP03/10126**

(43) Veröffentlichungstag der Anmeldung:
**07.06.2006   Patentblatt 2006/23**

(73) Patentinhaber: **Cherry GmbH
91275 Auerbach/Opf. (DE)**

(72) Erfinder:
• **ZAPF, Martin
95473 Creussen (DE)**
• **LUBER, Thomas
92256 Hahnbach (DE)**

(74) Vertreter: **Leske, Thomas
Frohwitter, Patent-u. Rechtsanwälte,
Possartstrasse 20
81679 München (DE)**

(56) Entgegenhaltungen:
WO-A-20/04027994       DE-A- 2 653 371
DE-A1- 10 242 385       US-A- 4 658 153
US-A- 6 043 644       US-B1- 6 179 938

EP 1 665 536 B1

**Beschreibung**

Die Erfindung bezieht sich auf eine induktive Schaltvorrichtung mit einer Sensoreinheit, die insbesondere für eine Positionsschaltvorrichtung brauchbar ist, die bei automatischen Fahrzeuggetrieben eingesetzt wird.

Bekannt im Stand der Technik ist ein Weg-Winkel-Sensor, insbesondere zur Bestimmung eines eingelegten Ganges im Kraftfahrzeugbereich, gemäß der Patentschrift DE 198 06 529. Der bekannte Weg-Winkel-Sensor weist vier Meßspulen auf, die in einer X-Y-Fläche auf einem Spulenträger in einem Winkel von 90° zueinander angeordnet und an eine Auswerteelektronik angeschlossen sind. Der Sensor weist auch ein sogenanntes Target auf, das im Wesentlichen parallel zu der X-Y-Fläche relativ zu den Meßspulen bewegbar ist und dadurch in den Meßspulen Spannungen induziert. Aus den induzierten Spannungen kann die Auswerteelektronik den zurückgelegten Weg in Y-Richtung und den Winkel $\alpha$ des Targets in einer Z-X-Fläche ermitteln. Der bekannte Weg-Winkel-Sensor zeichnet sich dadurch aus, daß die jeweils gegenüberliegenden Meßspulen in einem Abstand zueinander angeordnet sind und die benachbarten Meßspulen sich jeweils zumindest teilweise überlagern.

In der älteren Anmeldung DE 102 42 385 A1 ist eine induktive Sensoreinheit mit mindestens zwei Sensorspulen offenbart, die nebeneinander planar auf einer Leiterfläche aufgebracht sind. Bei einem benachbarten leitfähigen Betätigungselement kann der Abstand x zu den Sensorspulen und die Überdeckung y der Sensorspulen verändert werden. Die Auswertung der dadurch entstehenden Induktivitätsänderungen findet wie bei induktiven Näherungsschaltern durch den Einbau der Sensorspulen in einen Schwingkreis statt. Eine derartige Resonanzauswertung ist temperaturanfällig und verhältnismäßig aufwendig.

Aus dem Automobilbereich ist ferner der vielfache Einsatz von mechanischen Schaltern bekannt, unter anderem in Schließsystemen, Bedienelementen der Armaturen, Sitzverstellungen, Spiegelverstellungen usw. Mechanische Schalter haben den Nachteil, daß sie nicht verschleißfrei arbeiten. Ihre Lebensdauer wird einerseits begrenzt durch den Materialabtrag des Kontaktmaterials, durch Materialveränderungen (Oxidation), durch Ablagerungen auf den Schaltkontakten in Folge mechanischer Reibung oder elektrischer Überlastung oder in Folge eines Lichtbogens beim Abschaltvorgang.

Eine besondere Form mechanischer Schalter sind mechanische Schleifschalter. Ein verschiebbarer Kontakt läuft über eine Schleifbahn und stellt damit je nach Position einen Kontakt zu wechselnden Anschlüssen her (sogenannte Kodierschalter). Im Fahrzeug auftretende Vibrationen führen bei einer derartigen Schaltkulisseneinheit zu einem erhöhten Verschleiß der Schleifkontakte und Schleifbahnen.

In modernen Fahrzeugen werden Verstellmotoren heute meist über verschleißfreie Leistungshalbleiter geschaltet, die dann allerdings wieder durch nicht verschleißfreie Schalter angesteuert werden. Um das System vollständig verschleißfrei zu gestalten, ist die Entwicklung von neuartigen Schaltern notwendig, die ohne mechanische Schaltkontakte (also mit Sensoren) arbeiten.

Bekannt im Stand der Technik sind Hall-Sensoren, die auf die Annäherung von Permanentmagneten reagieren und damit eine Schaltfunktion auslösen. Weiterhin bekannt ist die Verwendung von GMR-Sensoren, die auf dem Effekt einer Widerstandsänderung beruhen, die durch ein äußeres Magnetfeld hervorgerufen wird. Das äußere Magnetfeld kann einem Permanentmagneten oder einem magnetisierbaren Kunststoff entstammen und entsprechende Schaltfunktionen veranlassen.

Weiterhin ist der Einsatz von Lichtschranken und Reflexlichtschranken bekannt, die den Nachteil haben, daß sie störlichtempfindlich sind und daß die optischen Bauteile altern und leicht verschmutzen können. Der Einsatz solcher Sensoren hat ferner den Nachteil, daß sie im Vergleich zu mechanischen Schaltern und zu induktiven Schaltern teuer sind.

In Schaltelementen wird als Träger für Beleuchtungen, Anzeigen oder mechanische Schalter oft eine kostengünstige Leiterplatte verwendet. Das Vorhandensein einer solchen Leiterplatte begünstigt den Einsatz der vorliegenden Erfindung. Als kostengünstige Möglichkeit ist das beispielsweise in der Offenlegungsschrift DE 101 25 278 verwendete Wirkungsprinzip der induktiven Kopplung zweier auf der Leiterplatte aufgebrachter Sensorspulen und deren Bedämpfung durch einen leitfähigen Betätiger offenbart. Dabei korreliert die Bedämpfungsstärke mit der Position des Betätigers relativ zu den Sensoren. Nachteilig an dieser Technologie kann sich auswirken, daß die Sensoren in der praktischen Ausführung eine Mindestgröße von ca. 10 mm x 10 mm auf der Leiterplatte haben müssen, damit eine annehmbare Kopplung erreicht werden kann und damit die Aufbereitungselektronik einfach und kosteneffektiv gestaltet werden kann. Bei den derzeit kostengünstig produzierbaren Leiterplatten wird eine örtliche Auflösung von 0,12 mm erreicht, d.h. die Leiterbreite der Sensorwicklungen kann maximal 0,12 mm betragen, ebenso wie die Isolierbreite zwischen den Wicklungen- Dadurch bedingt kann die Sendespule wie auch die Empfangsspule der Sensoren nur ca. 5 Windungen aufweisen.

Die Aufgabe der Erfindung besteht darin, die Induktivität von Sensorspulen durch einen über die Spule gebrachten Betätiger zu beeinflussen und diese Induktivitätsänderung in einfacher Weise auszuwerten.

Die Induktivität einer Spule ändert sich erheblich durch ein leitfähiges Betätigungselement, das gemäß dem unabhängigen Anspruch 1 einen veränderlichen Abstand x zu den Sensorspulen und/oder eine veränderliche Überdeckung y der Sensorspulen aufweist. Die Aufgabe wird durch eine induktive Schaltvorrichtung mit den Merkmalen des Anspruchs 1 gelöst. Zweckmäßige Weiterbildungen sind in den abhängigen Ansprüchen definiert.

Eine ungedämpfte Sensorspule mit einem Außenmaß von 10 mm x 10 mm, die auf der Leiterplatte wie eine rechteckige Spirale von innen nach außen gewickelt ist, weist bei der auf der Leiterplatte erzielbaren Auflösung 10 Windungen und eine Induktivität von ca. 1 μH auf.

Zwar ist es aus der Druckschrift GB 1 415 644 bekannt, die Impedanz einer Spiralstruktur als Sensor zu verwenden, jedoch ist die bekannte Spiralstruktur bifilar gewickelt, um die ohmsche Komponente der Spiralimpedanz auszunutzen und um die induktive Komponente der Spiralimpedanz auszuschalten. Im Unterschied dazu ist die Sensorspule gemäß der Erfindung monofilar gewickelt, wie sich aus der nachfolgenden detaillierten Beschreibung anhand der Figuren ergibt.

Figur 1 zeigt die planare Ausführung einer Sensorschleife auf einer Leiterplatte zusammen mit dem elektrotechnisch äquivalenten Symbol L.

Figur 2 zeigt ein funktionelles Blockschaltbild einer erfindungsgemäßen Schaltvorrichtung mit Sensoreinheit mit einer Reaktanzmessung als Auswerteschaltung.

Figur 3 zeigt ein funktionelles Blockschaltbild mit einer Reaktanzauswertung und mit zwei durch Multiplex angesteuerten Sensoren zur Detektion eines Verschiebewegs y.

Figur 4 zeigt eine typische Kennlinie für die Induktivität eines ersten Sensors L1 gemäß Figur 3 und eines zweiten Sensors L2 gemäß Figur 3 als Funktion des Verschiebeweges y.

Figur 5 zeigt eine Schaltkulisse für ein Kraftfahrzeug mit einem Automatikwählhebel, der an eine Schaltvorrichtung gemäß Figur 3 oder Figur 6 angeschlossen ist.

Figur 6 zeigt das Schema einer Leiterplatte mit mehreren Sensoreinheiten für die Schaltkulisseneinheit gemäß Figur 5.

Figur 7 zeigt das Blockschaltbild einer elektronischen Einheit, wenn mehrere induktive Sensoren kombiniert werden.

Figur 8 zeigt die normierte Induktivität der Sensorsignale der verschiedenen Schalteinheiten in Figur 7 bei Schaltvorgängen des Automatikwählhebels von der Position 1 bis zur Position 4.

Figur 9 zeigt ein ähnliches Schema einer Leiterplatte wie in Figur 6, jedoch mit einer redundanten Schalteinheit.

Figur 10 zeigt das Blockschaltbild einer Auswerteeinheit mit Spannungseinprägung.

Figur 11 zeigt die gemäß Fig. 10 ausgewertete Induktivitätsänderung.

Figur 12 zeigt das Blockschaltbild einer Auswerteeinheit mit Stromeinprägung.

Figur 13 zeigt die gemäß Figur 12 ausgewertete Induktivitätsänderung.

Figur 14 zeigt eine Null-Normierung der gemäß Figur 13 gemessenen Induktivität.

Figur 15 zeigt eine Abhängigkeit der Null-Normierung gemäß Figur 14, wenn sich zusätzlich der Abstand x gemäß Figur 3 ändert.

Figur 16 zeigt eine Quotientenbildung, um vom der Abstandsabhängigkeit gemäß Figur 15 unabhängig zu werden.

Figur 17 zeigt eine logarithmische Auswertung der Quotienten gemäß Figur 16 zur Bestimmung der genauen Wegposition y.

Figur 18 zeigt eine Definition von Schaltschwellen bei y-Verschiebungen gemäß den Figuren 12 bis 17.

Figur 19 zeigt eine Verschiebung der Schaltschwellen gemäß Figur 18.

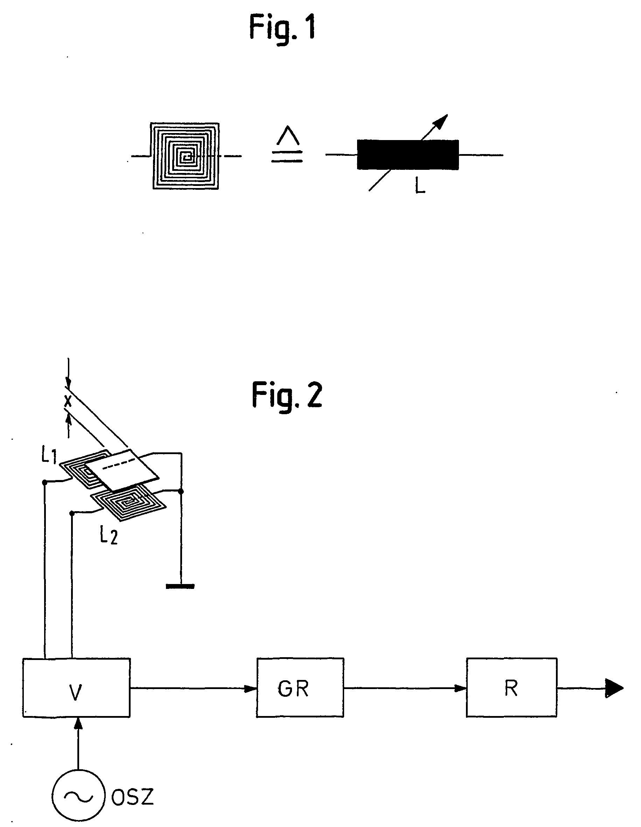

Gemäß Figur 1 ist eine Sensorspule planar auf einer Leiterplatte aufgebracht. Der Anschluß im Mittelpunkt der Spirale ist beispielsweise auf der Rückseite der Leiterplatte herausgeführt. Deckt man den Sensor gemäß Figur 1 mit einem leitfähigen Betätiger im Abstand x von beispielsweise x = 0,05 mm ab, so verringert sich die Induktivität von beispielsweise ca. 1 μH auf beispielsweise ca. 0,2 μH.

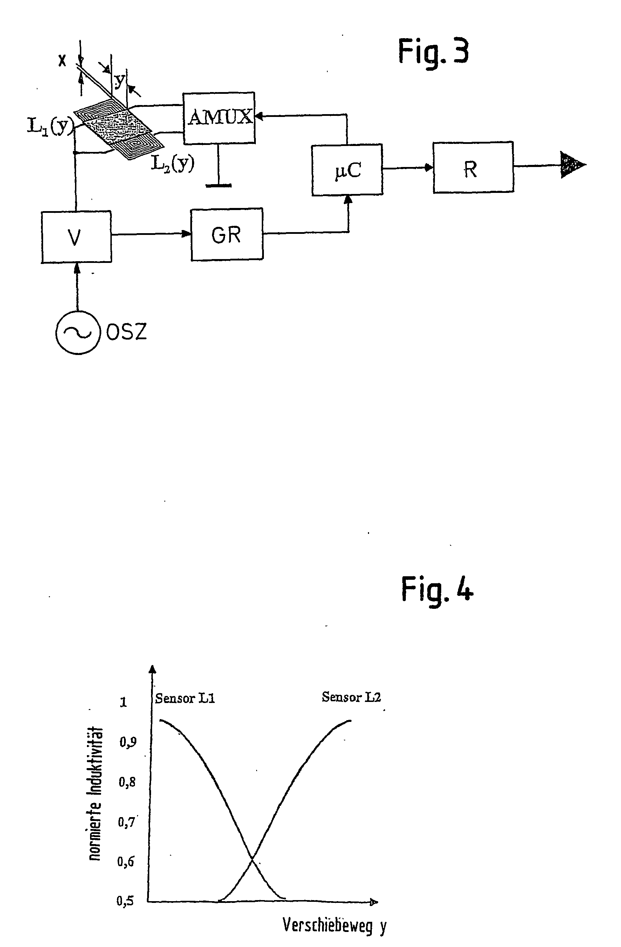

Die Verringerung der Induktion durch den Betätiger B ist vom Abstand x des Betätigers B zur Sensorschleife abhängig (Figur 2); sie ist aber auch vom Überdeckungsgrad der Sensorschleife durch das Betätigerelement abhängig (Figur 3). Überdeckt der Betätiger die gesamte Fläche einer Schleife gemäß Figur 1 in einem konstanten Abstand x, so wird die Amplitude der Sensorspannung bei dem Überdeckungsgrad von 100 % minimal, wobei die Größe der minimalen Sensorspannung von dem Abstand x abhängt. Die Reaktanz L ist somit variabel (Figur 1).

Damit sind für den Schalter zwei Schaltmechanismen möglich:

- Der Überdeckungsgrad G wird auf einer definierten Größe gehalten, und der Abstand x zwischen dem Betätigerelement B und den Sensorschleifen wird variiert (wie es z.B. in Figur 2 dargestellt ist), oder

- der Abstand x wird relativ konstant gehalten und der Überdeckungsgrad G wird verändert (wie es z.B. durch die y-Verschiebung in Figur 3 dargestellt ist).

- Auch eine Kombination der beiden Schaltmechanismen x und y ist möglich (Figur 3).

Als kostengünstige Auswerteelektronik hinlänglich bekannt ist ein LC-Schwingkreis, bestehend aus einer Sensorinduktivität L, einer Festkapazität C und einem invertierenden Verstärker, in dessen Rückkopplungszweig der LC-Schwingkreis eingebaut ist. Die Frequenz des Schwingkreises wird durch die Resonanzfrequenz des LC-Gliedes bestimmt nach der Formel:

$$f_r = \frac{1}{2\pi} \; x \; \frac{1}{\sqrt{LC}} \; .$$

Ein nachgeschalteter Frequenzzähler bestimmt die Schwingungen pro Zeiteinheit und gibt sie als Signalwert aus. Für eine einfache Schaltfunktion genügt es, mittels eines Komparators den aktuellen Frequenzwert mit einem Schwellwert zu vergleichen und damit die Schaltfunktion auszulösen. In einem gewöhnlichen Fall wird das Schaltsignal auf "1" gesetzt, wenn die Frequenz höher ist als eine eingestellte Grenzfrequenz, was einer geringeren Induktivität durch eine höhere Bedämpfung entspricht. Bei einer geringeren Frequenz gibt der Komparator eine "0" aus. Über einen nachgeschalteten Hoch-Niedrig-Schalter oder ein Relais können dann hohe Leistungen geschaltet werden. Die Funktionen Frequenzzähler und Komparator können aber auch als sogenannte Firmware in einem Mikrocontroller realisiert sein.

Damit kann auf einfache Weise ein verschleißfreier Tastschalter in einer Bedieneinheit des Automobils realisiert werden. Das Bedämpfungselement wird durch Druck auf eine Taste an den Sensor angenähert und dort mittels eines Verriegelungsmechanismus gehalten. Erst bei erneutem Druck auf den Tastenknopf wird die Verriegelung aufgehoben, und der Betätiger wird in seine Ruheposition in einem größeren Abstand zum Sensor gebracht (Kugelschreiberverriegelungsprinzip). So lassen sich auf einfache und kostengünstige Weise Schalttaster wie etwa Schalter für Warnblinker, Nebelleuchten, Heckscheibenheizung usw. realisieren.

In Applikationen, in denen sehr genaue Schaltpunkte erforderlich sind, sind oft die Temperatureinflüsse auf Verstärker, Kapazitäten, Komparatoren usw. problematisch. In temperaturstabilen Applikationen kann man diese Einflüsse erfindungsgemäß umgehen, indem man zwei Sensoren nebeneinander auf einer Leiterplatte aufbringt und beide gleichzeitig oder wechselseitig einschaltet (vgl. Figur 2 oder 3). Das Zuschalten der Induktivität L1 oder L2 geschieht durch einen Schalttransistor oder Feldeffekttransistor oder MOSFET (Figur 2) oder einen Analogmultiplexer AMUX (Figur 3). Wendet man eine relative Auswertung an, indem man als Schaltkriterium das Verhältnis der ersten Sensorreaktanz zur zweiten Sensorreaktanz verwendet, so fallen die Störeinflüsse heraus. Die Schaltung ist sehr temperaturstabil.

Diese Schaltungsart erweist sich auch bei Applikationen als vorteilhaft, bei denen die Position y des Betätigers relativ zu den Sensorpositionen detektiert wird, während der Abstand x des Betätigers zum Sensor mehr oder weniger konstant gehalten wird (wie z.B. bei Weg-Winkel-Sensoren). Auch hier findet gemäß Figur 3 eine relative Auswertung statt, die am besten, jedoch nicht ausschließlich, durch einen Mikrocontroller μC erfolgen kann.

Figur 4 zeigt zwei typische Kennlinien der normierten Reaktanz als Funktion des Verschiebeweges y. In dem Verschiebebereich zwischen den Maxima der Kennlinien L1 und L2 kann der Mikrocontroller μC eine exakte Positionserkennung vornehmen. In weiteren praktischen Anwendungsfällen können noch mehr Sensoren zur Erkennung der Betätigerposition verwendet werden.

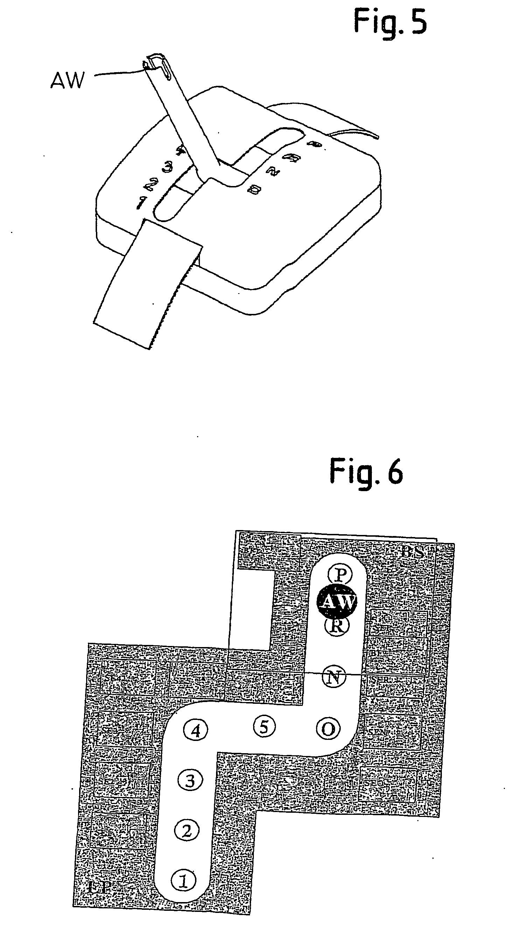

Sind in einem Anwendungsfall, wie er in Figur 5 als Schaltkulisse für ein Kraftfahrzeug dargestellt ist, mehrere Positionen zu detektieren, so ist es zweckmäßig, mehrere induktive Sensoren als Funktionseinheit zu kombinieren. Am Beispiel der Umsetzung der Positionserkennung eines Automatikwählhebels sieht das wie folgt aus:

Unter einer Blende wie in Figur 5 wird eine Leiterplatte wie in Figur 6 positioniert, auf deren Oberseite z.B. die Hinterleuchtung der Blendenanzeigen 1, 2, ... P montiert werden kann. Mit dem Automatikwählhebel AW (siehe Figur 5 und 6), der durch einen Ausbruch in der Leiterplatte taucht, ist ein Betätigerschlitten BS verbunden, der auf der Unterseite der Leiterplatte LP plan aufliegt und auf dem ein Betätiger oder mehrere Betätiger (in Figur 6 z.B. die Betätigerflächen BF1 und BF2) angebracht sind. Die Betätigerflächen werden in einem definierten Abstand x über die verschiedenen Sensoreinheiten SE geschoben.

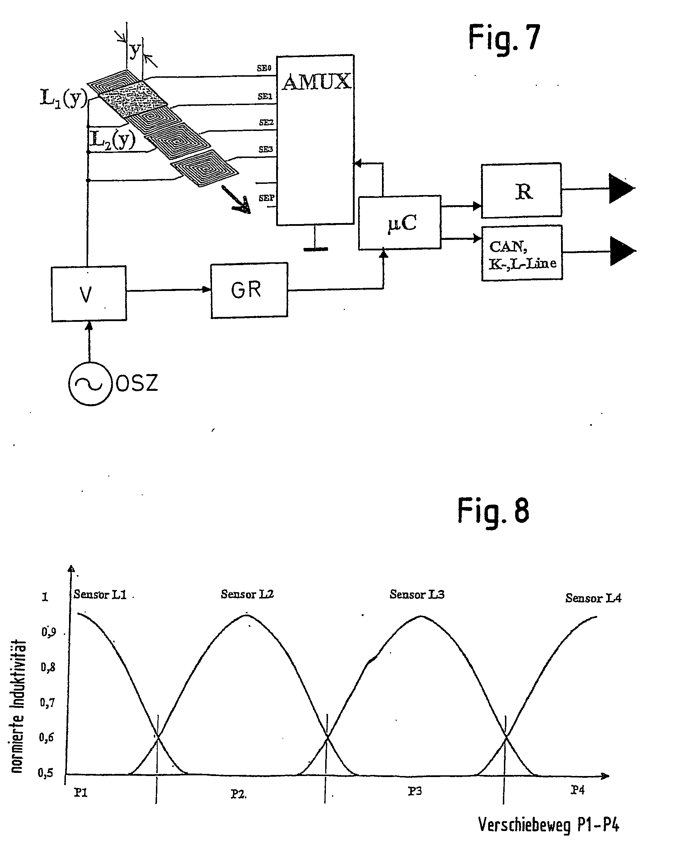

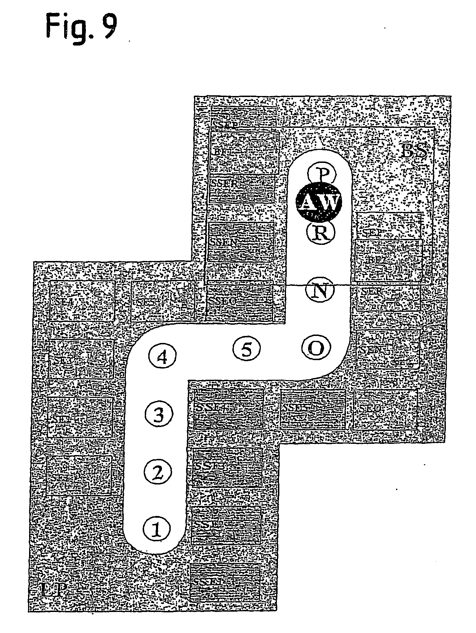

Mit dem Begriff der Verschiebung ist eine Bewegung des Betätigerschlittens gemeint, die geradlinig sein oder die Richtung wechseln kann. Die zu überstreichenden Sensorspulen können auf einer geraden Linie aufgereiht sein, wie es prinzipiell in Figur 7 dargestellt ist. Die Sensorspulen können jedoch auch gemäß einer komplexeren Topologie nebeneinander liegen, wie sie beispielsweise für Schaltkulissen gemäß den Figuren 6 und 9 angewendet wird.

Ferner kann die Topologie der benachbarten Sensorspulen (Gerade, Polygonzug, sonstige Bahn) auf einer ebenen oder auf einer gekrümmten Leiterplatte liegen. In Figur 7 ist eine ebene Anordnung von Sensorspulen dargestellt, während in Figur 5 und 6 ein Beispiel für eine gekrümmte Leiterplatte dargestellt ist, die unter der gebogenen Schaltkulisse angeordnet ist. In beiden Fällen wird der Betätigerschlitten in einem Abstand x, der im wesentlichen konstant oder auch veränderlich sein kann, oberhalb der Anordnung von Sensorspulen verschoben.

Eine weitere Variante der beanspruchten Verschiebung ergibt sich, wenn man die gekrümmte Leiterplatte, die gemäß Figur 5 der gebogenen Kulisse folgt, durch eine ebene Leiterplatte ersetzt, die in einer senkrecht zur Fläche der Kulisse laufenden Ebene angeordnet ist. In diesem Fall wird auch der Betätigerschlitten senkrecht gestellt und nacheinander über Sensorschleifen geschoben, die z.B. kreisbogenförmig auf der senkrechten, ebenen Leiterplatte aufgebracht sind.

Bei der Kombination mehrerer induktiver Schalter stellt sich das Blockschaltbild wie in Figur 7 dar. Die zugehörigen Amplituden der Sensorsignale bei Schaltvorgängen des Automatikwählhebels sind in Figur 8 für die Positionen 1, 2, 3 und 4 zu erkennen, wobei die normierte Reaktanz über dem Verschiebeweg P1 - P4 für die Sensoren L1 - L4 aufgetragen ist. Die jeweiligen Umschaltschwellen P1 - P2, P2 - P3 und P3 - P4 sind eingetragen.

Auch eine redundante und damit sichere Positionserkennung ist ohne großen Zusatzaufwand zu realisieren, wie z.B. in Figur 9 dargestellt. Es wird dort vorgeschlagen, statt einer Sensoreinheit pro Position zwei Sensoreinheiten pro Position aufzubauen und die Signale zu vergleichen. Bei widersprüchlichen Ergebnissen wird die Auswerteeinheit die Schaltfunktion so ausführen, daß das gesamte System in einen sicheren Zustand gebracht wird. Die Leiterplatte kann dazu beispielsweise mit Sicherheitssensoreinheiten SSE gemäß Figur 9 erweitert werden.

Die Auswerteeinheit für das Sensormodul wird in der Regel ein Mikrocontroller sein, der über eine Schnittstelle (CAN, LIN, etc.) die Schaltinformationen an die Steuerelektronik bzw. Leistungselektronik weitergibt.

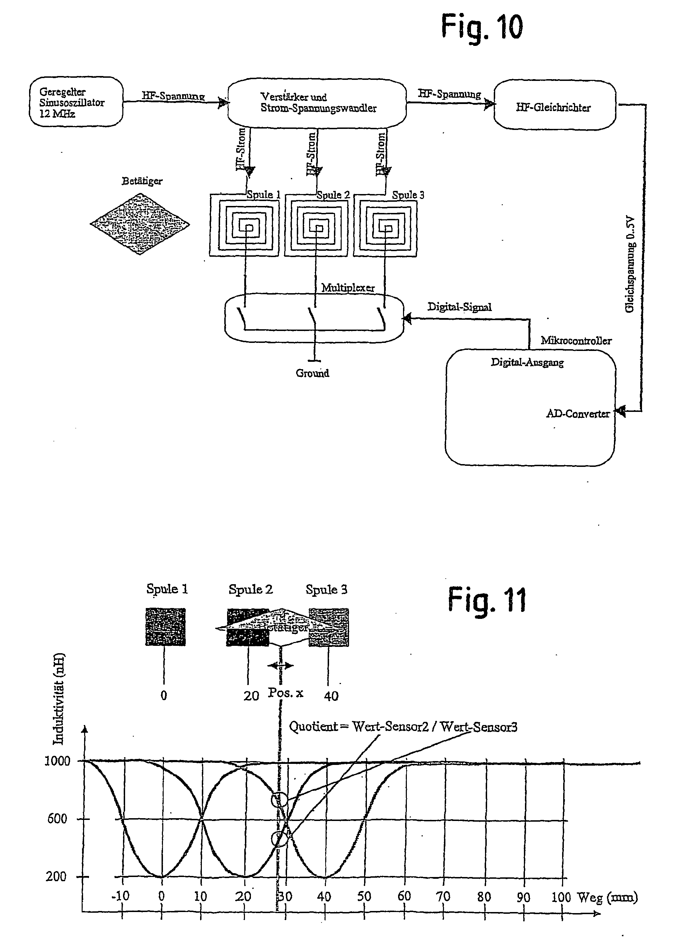

Die Signalauswertung erfolgt bei mehreren Sensorspulen insbesondere über einen Multiplexer (Figur 3, Figur 7), der nur jeweils eine der Sensorspulen der Auswerteschaltung zuschaltet. Hierfür zeigen die Figuren 10 und 11 ein Ausführungsbeispiel der Signalauswertung, das ähnlich dem in den Figuren 7 und 8 dargestellten Ausführungsbeispiel eingesetzt werden kann.

Gemäß den Figuren 10 und 11 wird die Grenze zwischen den Positionen zweier benachbarter Sensorspulen durch einen direkten Vergleich der jeweiligen induktiven Reaktanz festgestellt. Nach dem Blockschaltbild in Figur 10 erzeugt ein Sinusoszillator eine Wechselspannung von 12 MHz; diese wird verstärkt und als Spannung in je eine der drei Sensorspulen, die im Zeitmultiplex eingeschaltet werden, eingespeist. Bewegt man den Betätiger, der aus leitfähigem Material besteht, über die Spulen, verringert sich durch Wirbelstromverluste die Induktivität der Spulen. Dadurch verringert sich auch die Reaktanz, die folgendermaßen berechnet wird: XL = 2 * PI * f * L (f= 12 MHz). Hat zum Beispiel eine Spule eine Induktivität von 1000 nH ohne Betätiger und 200 nH mit Betätiger, so folgt aus obiger Gleichung ein XL von 75 Ohm bzw. 15 Ohm. Bei konstanter Wechselspannung fließt ein Strom, der von der Überdeckung des Betätigers abhängt. Dieser Strom wird in eine proportionale HF-Spannung umgewandelt und gleichgerichtet dem Mikrocontroller zugeführt.

Das Auswertekonzept des Mikrocontrollers ist in Figur 11 dargestellt. Der Mikrocontroller misst zyklisch in festen Zeitschlitzen von z.B. 2 ms die gleichgerichtete Spannung jedes Sensors. Bewegt man den Betätiger in festen Weg-Schritten über die Sensoren und zeichnet die Spannungen auf, so entstehen die Kurven wie in Figur 11 gezeigt. Mit zusätzlichen Sensoren kann der Wegbereich vergrößert werden. Im statischen Zustand des Betätigers werden immer nur zwei Werte ausgewertet, d.h. für den Mikrocontroller sind zu jedem Zeitpunkt nur zwei benachbarte Messwerte vorhanden. In der Auswertefirmware im Mikrocontroller wird der Quotient aus zwei benachbarten Sensorspannungen berechnet und mit einem festen Wert verglichen. Je nachdem, ob der Quotient größer oder kleiner als der feste Wert ist, wird die eine oder die andere Schaltposition ermittelt.

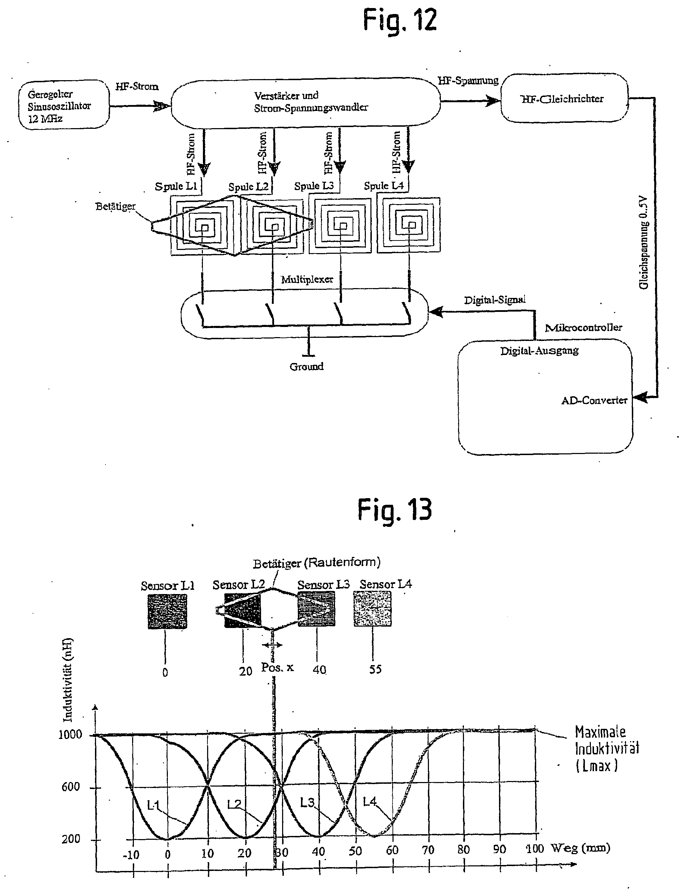

In Figur 12 ist - als Alternative zur Spannungseinspeisung gemäß Figur 10 - eine Stromeinspeisung in die Spulenreaktanzen dargestellt. Ein Sinusoszillator erzeugt einen Wechselstrom mit konstanter Amplitude und konstanter Frequenz von beispielsweise f = 12 MHz. Dieser Wechselstrom wird verstärkt und nacheinander in je eine der beispielsweise vier Sensorspulen L1 bis L4 eingespeist.

Bewegt man den Betätiger, der aus gut leitfähigem Material (beispielsweise Kupfer oder Messing) besteht, über die Spulen hinweg, so verringert sich durch Wirbelstromverluste die Induktivität L der Spulen. Dadurch verringert sich auch der induktive Widerstand XL, der folgendermaßen berechnet wird: XL = 2 * PI * F * L. Bedeckt der Betätiger eine Spule nicht, so weist sie eine Induktivität von beispielsweise 1000 nH auf. Bedeckt dagegen der Betätiger eine Spule voll, so weist sie eine Induktivität von beispielsweise 200 nH auf. Aus der obigen Gleichung folgt dann ein induktiver Widerstand XL von beispielsweise 75 Ohm bzw. beispielsweise 15 Ohm.

Der Spannungsabfall an einer der Spulen L1 bis L4 wird gleichgerichtet und einem Microcontroller zur Weiterverarbeitung zugeführt. Die Spulen wirken daher als Sensoren für den geometrischen Ort des Betätigers.

Die weitere Signalauswertung ist in Figur 13 dargestellt. Der Microcontroller misst zyklisch in festen Zeitabständen die Spannungen der Sensoren L1 bis L4, die proportional zu ihren Induktivitäten sind. Bewegt man einen rautenförmigen Betätiger in festen Weg-Schritten über die Sensoren und zeichnet die Spannungen auf, so entstehen die annähernd sinusförmigen Kurven wie in Bild 13 gezeigt. Mit zusätzlichen Sensoren kann der Wegbereich vergrößert werden.

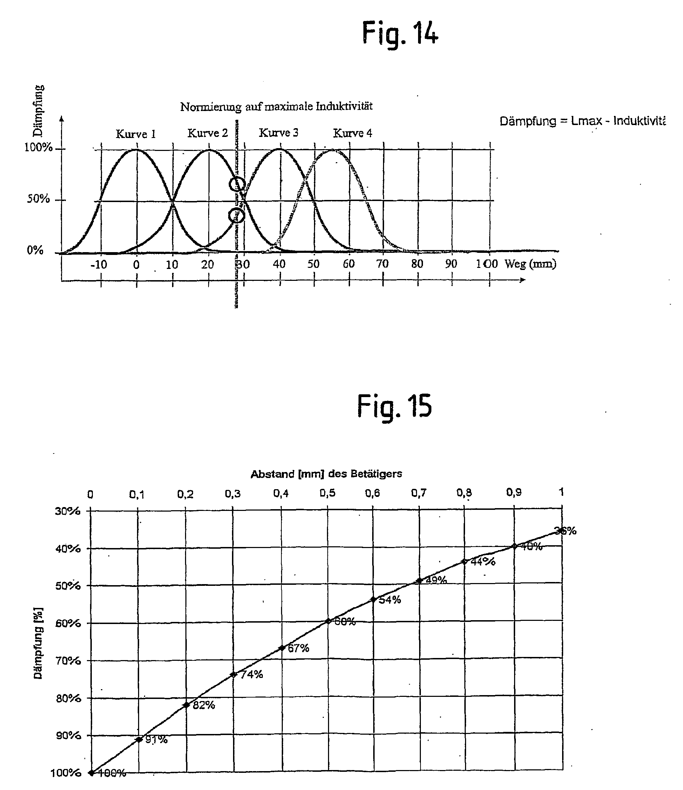

Im nächsten Verarbeitungsschritt wird gemäß Figur 14 eine Null-Normierung vorgenommen. Zunächst wird aus den Kurven gemäß Figur 13 die Sensornummer und das Sensorsignal mit der höchsten Induktivität Lmax ermittelt, im Beispiel 1000 nH. Danach subtrahiert man die Sensorwerte von Lmax und bekommt dann die vier Dämpfungskurven in Figur 14.

Ist ein Sensor nicht vom Betätiger bedeckt, so beträgt die Dämpfung 0%, bei vollbedecktem Sensor beträgt sie 100%.

Die Dämpfung ist aber auch noch vom Abstand des Betätigers zu den Sensorspulen abhängig. Bei größerem Abstand verringert sich die maximale Dämpfung, wie in Figur 15 zu sehen ist.

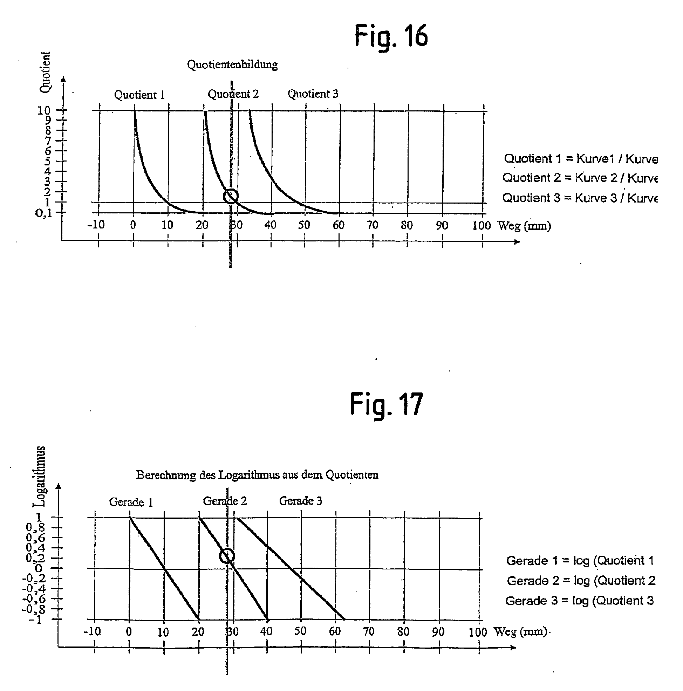

Um unabhängig von dieser Abstandsänderung zu werden (bei manchen Positionsschaltvorrichtungen für automatische Getriebe sind Abstandsänderungen nicht zu vermeiden), bildet man die Quotienten aus zwei benachbarten Kurven. Daraus erhält man beispielsweise die drei Quotientenkurven, die in Figur 16 dargestellt sind.

Um einen linearen Zusammenhang zwischen Weg und Signal zu erreichen, werden die Quotientenkurven anschließend logarithmiert (Figur 17). Je genauer die Kurvenformen in Figur 14 einer Sinusform entsprechen, desto linearer werden die logarithmierten Kurven gemäß Figur 17.

Anhand der Steigung und anhand eines Punktes auf je einer Geraden kann - von jedem Logarithmuswert ausgehend - die genaue Wegposition y festgestellt werden (Figur 17).

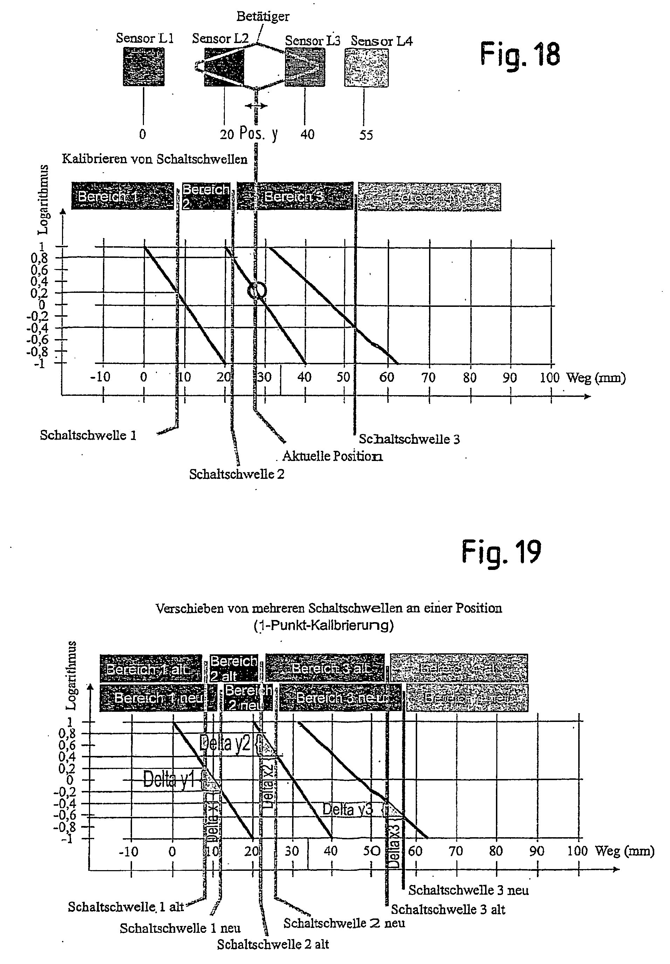

Die Figur 18 zeigt eine Einstellung von Schaltschwellen. Automatikschaltungen in Automobilen haben in der Regel vier Schaltstellungen (Bereiche): Parken (park), Rückwärts (reverse), Neutral (neutral) und Fahren (drive). Beim Einsatz des Sensorsystems muss deshalb zwischen vier Bereichen unterschieden werden. Zwischen den vier Bereichen liegen drei Schaltschwellen. Jede Schaltschwelle kann eingestellt werden, indem man die Ordinatenwerte aller Geraden gemäß Figur 17 bei bestimmten Wegpositionen abspeichert. Diese Schaltschwellen werden folgendermaßen eingestellt:

Der Betätiger wird an die erste Position (z.B. 8 mm) gebracht; jetzt wird der Wert auf der ersten Geraden abgespeichert (z.B. 0,2). Bei den weiteren Schaltschwellen wird genauso verfahren. Im Betrieb wird laufend der Ordinatenwert auf der momentan geschnittenen Geraden mit den Schaltschwellen verglichen. Im Beispiel Figur 18 ist die aktuelle Position des Betätigers bei 28 mm. Der Wert auf der Ordinate 0,2 ist hier kleiner als der Ordinatenwert der zweiten Schaltschwelle (0,8). Das bedeutet, dass die aktuelle Position des Betätigers im Bereich 3 liegt.

In Figur 19 ist abschließend ein Verschieben aller Schaltschwellen an einer einzigen Position dargestellt. In der Praxis kann es vorkommen, dass der komplette Sensoraufbau mit den bereits eingestellten Schaltschwellen mechanisch verschoben wird. Dann müssten theoretisch alle Schaltschwellen gemäß Figur 18 wieder neu eingestellt werden.

Mit einer "1-Punkt-Kalibierung" ist es vorzugsweise möglich, an einer einzigen Position alle Schaltpunkte um den gleichen Wert zu verschieben. Dazu müssen die Steigungen aller Geraden gemäß Figur 17 und Figur 18 bekannt sein. Im Beispiel der Figur 19 sollen die Schaltschwellen von "alt" nach "neu" verschoben werden. Dazu wird der Betätiger an die Position "Schaltschwelle neu" bewegt. Anhand der Differenz ΔY1 der beiden Punkte auf der Ordinate (P 1 = 0,2 und P2 = -0,2) und anhand der Steigung der ersten Geraden kann die Wegdifferenz ΔX1 berechnet werden. Mit dieser Information können bei den weiteren Geraden die Ordinatenwerte der neuen Schaltschwellen berechnet werden. Die neuen Ordinatenwerte werden nun in einem nicht flüchtigen Speicher abgelegt und werden von nun an als Schaltschwellen verwendet.

**Patentansprüche**

1. Induktive Schaltvorrichtung
   mit einem Verriegelungsmechanismus oder einem rastbaren Wählhebel,
   mit einer Sensoreinheit und
   mit einer Auswerteschaltung,
   wobei die Sensoreinheit versehen ist

   - mit mindestens zwei Sensorspulen (L1, L2, usw.), die auf einer Leiterplatte untergebracht sind,
   - und mit mindestens einem leitfähigen Betätigungselement, dessen Abstand (x) zu zwei benachbarten Sensorspulen (L1, L2) oder dessen Überdeckung (y) je zweier Sensorspulen (L1, L2, usw.) zwecks Änderung ihrer Induktivität veränderbar ist,

   wobei die Induktivitätsänderungen in der Auswerteschaltung Schaltfunktionen auslösen, und zwar durch einen Vergleich der induktiven Reaktanz benachbarter Sensorspulen (L1, L2), **dadurch gekennzeichnet, dass** der Vergleich der induktiven Reaktanz benachbarter Sensorspulen (L1, L2, usw.) als logarithmische Funktion der Spulenüberdeckung (y) gespeichert ist und dass in dieser Darstellung (Fig. 18) eine Schaltschwelle zwischen je zwei Schaltbereichen gespeichert ist, deren Überschreitung die jeweilige Schaltfunktion auslöst.

2. Induktive Schaltvorrichtung nach Anspruch 1, **dadurch gekennzeichnet, dass** eine Wechselspannung konstanter Amplitude und konstanter Frequenz (f) in die Sensorspulen (L1, L2) eingeprägt wird und anschließend die Stromamplitude der veränderlichen Induktivitäten (L1, L2, usw.) ausgewertet wird.

3. Induktive Schaltvorrichtung nach Anspruch 1, **dadurch gekennzeichnet, dass** ein Wechselstrom konstanter Amplitude und konstanter Frequenz (f) in die Sensorspulen (L1, L2) eingeprägt wird und anschließend die Spannungsamplitude der veränderlichen Induktivitäten (L1, L2, usw.) ausgewertet wird.

4. Induktive Schaltvorrichtung nach einem der vorhergehenden Ansprüche, **gekennzeichnet durch** eine Schiebeschalter-Verwendung als Positionsschaltvorrichtung für ein automatisches Fahrzeuggetriebe.

5. Induktive Positionsschaltvorrichtung nach Anspruch 4 mit einem Wählhebel (AW) und einem Betätigerschlitten (BS), der das leitfähige Betätigungselement trägt und im Wesentlichen horizontal verschiebt.

6. Induktive Schaltvorrichtung nach einem der Ansprüche 1 bis 3, **gekennzeichnet durch** eine Verwendung als induktiver Tastschalter mit einem Verriegelungsmechanismus nach dem Kugelschreiberprinzip, der das leitfähige Betätigungselement trägt.

7. Induktive Schaltvorrichtung nach einem der vorhergehenden Ansprüche, bei der zur Bildung eines temperaturstabilen und exakten Schaltkriteriums nur jeweils eine der Sensorspulen (L1, L2, usw.) der Auswerteschaltung zuschaltbar ist.

8. Induktive Schaltvorrichtung nach Anspruch 7, **dadurch gekennzeichnet, dass** die Signalauswertung der Sensorspulen über einen Multiplexer (AMUX) erfolgt.

9. Induktive Schaltvorrichtung nach Anspruch 7, **dadurch gekennzeichnet, dass** die Signalauswertung der Sensorspulen (L1, L2, usw.) über einen MOSFET-Schalter erfolgt.

10. Induktive Schaltvorrichtung nach einem der vorhergehenden Ansprüche, **dadurch gekennzeichnet, dass** die Speicherung der Funktionsgraphen (Geraden in Fig. 18) durch Parameter geschieht (Steigung und Punkt der geraden Funktionen in Fig. 18) und dass mehrere Schaltschwellen durch eine 1-Punkt-Kalibrierung gleichzeitig eingestellt werden.

**Claims**

1. Inductive switch apparatus
   having a locking mechanism or a lockable gearshift lever,
   having a sensor unit, and
   having an evaluation circuit,
   whereby said sensor unit is provided

   - with at least two sensor coils (L1, L2, etc.) that are housed on a printed circuit board,

   - and with at least one conductive actuator element, the distance (x) from which to two sensor coils (L1, L2) or whose coverage (y) of two sensor coils (L1, L2, etc.) can be changed for the purpose of changing its inductance,
   wherein the inductance changes trigger switching functions in said evaluation circuit, specifically using a comparison of the inductive reactance of adjacent sensor coils (L1, L2),
   **characterized in that** the comparison of the inductive reactance of adjacent sensor coils (L1, L2, etc.) that triggers the switching functions in the evaluation circuit is stored as a logarithmic function of the coil coverage (6) and **in that** one gear threshold between each two gear thresholds is stored in this depiction (Fig. 18), triggering the switching function when it is exceeded.

2. Inductive switch apparatus in accordance with claim 1, **characterized in that** an alternating voltage of constant amplitude and constant frequency (f) is impressed into said sensor coils (L1, L2) and then the current amplitude of the changing inductances (L1, L2, etc.) is evaluated.

3. Inductive switch apparatus in accordance with claim 1, **characterized in that** an alternating current of constant amplitude and constant frequency (f) is impressed into said sensor coils (L1, L2) and then the voltage amplitude of the changing inductances (L1, L2, etc.) is evaluated.

4. Inductive switch apparatus in accordance with any of the preceding claims, **characterized by** a sliding switch used as the position switch apparatus for an automatic vehicle transmission.

5. Inductive position switch apparatus in accordance with claim 4, having a gearshift lever (AW) and an actuator slide (BS) that carries the conductive actuator element and slides largely horizontal.

6. Inductive switch apparatus in accordance with any of claims 1 through 3, **characterized by** use as inductive momentary-contact switch having a locking mechanism using the ballpoint pen principle that carries the conductive actuator element.

7. Inductive switch apparatus in accordance with any of the preceding claims in which for forming a temperature-stable and precise switching criterion only one of said sensor coils (L1, L2, etc.) can be switched to said evaluation circuit.

8. Inductive switch apparatus in accordance with claim 7, **characterized in that** the signal evaluation of said sensor coils occurs via a multiplexer (AMUX).

9. Inductive switch apparatus in accordance with claim 7, **characterized in that** said signal evaluation of said sensor coils (L1, L2, etc.) occurs via a MOSFET switch.

10. Inductive switch apparatus in accordance with one of the preceding claims, **characterized in that** the storage of the function graphs (straight lines in Fig. 18) is performed by parameters (slope and point of straight line functions in Fig. 18) and **in that** a plurality of gear thresholds can be set simultaneously using a 1-point calibration.

## Revendications

1. Dispositif de commutation inductif avec un mécanisme de verrouillage ou un levier de sélection encliquetable avec un bloc détecteur et un commutateur d'analyse, dans lequel le bloc détecteur est prévu

 - avec au moins deux bobines de détection (L1, L2, etc.), lesquelles sont placées sur une carte de circuit imprimé,
 - et avec au moins un élément d'actionnement conducteur, dont la distance (x) par rapport aux deux bobines voisines (L1, L2) ou dont le recouvrement des deux bobines de détection (L1, L2, etc.) peut varier afin de modifier l'inductivité,

 moyennant quoi les modifications d'inductivité dans le commutateur d'analyse déclenchent des fonctions de commutation, c'est-à-dire en comparant la réactance inductive des bobines de détection voisines (L1, L2),
 **caractérisé en ce que** la comparaison de la réactance inductive des bobines de détection voisines (L1, L2, etc.) est enregistrée en tant que fonction logarithmique du recouvrement des bobines (y) et **en ce que** dans cette représentation (figure 18), un seuil de commutation entre deux zones de commutation respectivement est enregistré, dont le dépassement déclenche la fonction de commutation correspondante.

2. Dispositif de commutation inductif selon la revendication 1, **caractérisé en ce qu'**une tension alternative d'une amplitude constante et d'une fréquence constante (f) est appliquée dans les bobines de détection (L1, L2) et **en ce que** l'amplitude du courant des inductivités (L1, L2, etc.) variables est ensuite analysée.

3. Dispositif de commutation inductif selon la revendication 1, **caractérisé en ce qu'**un courant alternatif d'une amplitude constante et d'une fréquence constante (f) est appliqué dans les bobines de détection (L1, L2) et **en ce que** l'amplitude de la tension des inductivités variables (L1, L2, etc.) est ensuite analysée.

4. Dispositif de commutation inductif selon l'une quelconque des revendications précédentes, **caractérisé par** une utilisation de commutateur à coulisse comme dispositif de commutation de position pour un mécanisme de véhicule automatique.

5. Dispositif de commutation de position inductif selon la revendication 4 avec un levier de sélection (LS) et un coulisseau de commande (CC), lequel est porté par l'élément de commande conducteur et se déplace essentiellement horizontalement.

6. Dispositif de commutation inductif selon l'une quelconque des revendications 1 à 3, **caractérisé par** une utilisation comme bouton-poussoir inductif avec un mécanisme de verrouillage selon le principe du stylo à bille, lequel mécanisme porte l'élément de commande conducteur.

7. Dispositif de commutation inductif selon l'une quelconque des revendications précédentes, pour lequel une seule des bobines de détection respectivement (L1, L2, etc.) du commutateur d'analyse peut être mise sous tension pour former un critère de commutation précis et stable en température.

8. Dispositif de commutation inductif selon la revendication 7, **caractérisé en ce que** l'analyse du signal des bobines de détection a lieu via un multiplexeur (AMUX).

9. Dispositif de commutation inductif selon la revendication 7, **caractérisé en ce que** l'analyse du signal des bobines de détection (L1, L2, etc.) a lieu via un commutateur MOSFET.

10. Dispositif de commutation inductif selon l'une quelconque des revendications précédentes, **caractérisé en ce que** l'enregistrement des graphes de fonction (droites sur la figure 18) est effectué par un paramètre (pente et point des fonctions droites sur la figure 18) et **en ce que** plusieurs seuils de commutation sont définis simultanément par un calibrage à 1 point.

# Fig. 1

# Fig. 2

## Fig. 3

## Fig. 4

## Fig. 5

## Fig. 6

## Fig. 7

## Fig. 8

Verschiebeweg P1-P4

# Fig. 9

# Fig. 10

# Fig. 11

## Fig. 12

## Fig. 13

## Fig. 14

Normierung auf maximale Induktivität

Dämpfung = Lmax - Induktivitä

## Fig. 15

Abstand [mm] des Betätigers

# Fig. 16

Quotientenbildung

Quotient 1 = Kurve1 / Kurve

Quotient 2 = Kurve 2 / Kurve

Quotient 3 = Kurve 3 / Kurve

# Fig. 17

Berechnung des Logarithmus aus dem Quotienten

Gerade 1 = log (Quotient 1

Gerade 2 = log (Quotient 2

Gerade 3 = log (Quotient 3

Fig. 18

Fig. 19